# EUROPEAN PATENT APPLICATION

(11) **EP 4 336 561 A1**
(43) Date of publication of application: **13.03.2024**
(21) Application number: 22909698.7
(22) Date of filing: 01.12.2022
(51) Int. Cl.: H01L 29/739, H01L 21/331, H01L 29/06

(54) **INSULATED GATE BIPOLAR TRANSISTOR WITH SUPER JUNCTION STRUCTURE, AND PREPARATION METHOD THEREFOR**

(30) Priority: 21.12.2021 CN 202111573679
(71) Applicant: CHINA RESOURCES MICROELECTRONICS (CHONGQING) CO., LTD, Sha Ping Ba District Chongqing 401331 (CN)
(72) Inventor: ZHANG, Pengcheng, Chongqing 401331 (CN); WAN, Li, Chongqing 401331 (CN); MA, Xiandong, Chongqing 401331 (CN)
(74) Representative: Manitz Finsterwald Patent- und Rechtsanwaltspartnerschaft mbB
(86) International application number: PCT/CN2022/135910
(87) International publication number: WO 2023/116383

(57) **Abstract**

Provided in the present invention are an insulated gate bipolar transistor with a super junction structure, and a preparation method therefor. The transistor comprises a drift region of a first conduction type, an epitaxial layer, a plurality of trenches arranged at intervals, filling layers of a second conduction type, gate electrode structures, a body region, a body contact region, a source region, an isolation dielectric layer and a source electrode conductive layer, wherein the epitaxial layer is located on an upper surface of the drift region; the filling layers and the gate electrode structures are sequentially arranged in the trenches from bottom to top; each gate electrode structure comprises a gate conductive layer, and a gate dielectric layer, which is located on inner walls of the trench and an upper surface of the filling layer and wrap side walls and a bottom face of the gate conductive layer; the body contact region and the source region are located on an upper surface layer of the body region and are adjacent to an upper surface of the body region; the isolation dielectric layer is provided with a contact hole, which penetrates the isolation dielectric layer and exposes the source region and the body contact region; and the source electrode conductive layer fills the contact hole and covers the isolation dielectric layer. In the present invention, the filling layer is formed at the bottom of each trench so as to shield the overlapping area between the bottom of the trench and the drift region, thereby reducing gate electrode charges Q_{gc}.

## Description

### TECHNICAL FIELD

The present disclosure relates to the field of semiconductor integrated circuit manufacturing technology, and particularly to an insulated gate bipolar transistor with a super junction structure, and a manufacturing method thereof.

### BACKGROUND

Insulated Gate Bipolar Transistors (IGBT) are core devices for electric energy conversion and transmission, and are regarded as "CPU" of power electronic equipment. The key parameters of the IGBT devices include the forward voltage drop V_{ce}, switching loss E_{off} and short-circuit withstand time t_{sc}.

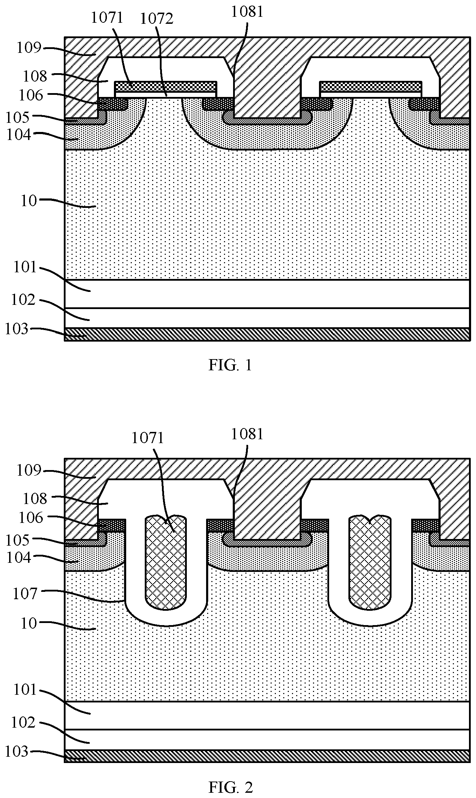

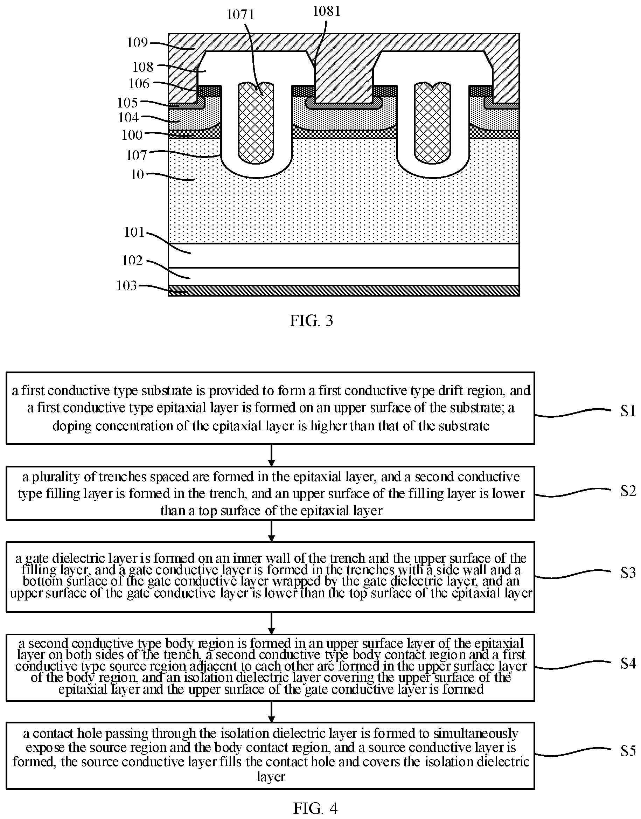

In the development process of the IGBT structure, the application of the trench gate technology and the carrier storage technology has greatly reduced the forward voltage drop V_{ce} and is an important technology for the IGBT. As shown in FIG. 1 which is a schematic cross-sectional structure diagram of a planar-gate type insulated gate bipolar transistor in the existing technology, including an N- drift region 10, an N buffer region 101, a P emitter 102, a drain 103, and a P- body region 104, a P+ contact region 105, a N+ source region 106, a gate electrode 1071, a gate oxide layer 1072, an isolation dielectric layer 108, and a source electrode 109. As shown in FIG. 2, which is a schematic cross-sectional structure diagram of a trench-gate type insulated gate bipolar transistor in the existing technology, including a N- drift region 10, a N buffer region 101, a P emitter 102, a drain 103, a P- body region 104, a P+ contact region 105, a N+ source region 106, a trench 107, a gate electrode 1071, an isolation dielectric layer 108, a contact hole 1081, and a source electrode 109. As for the trench gate technology, the trench IGBT structure excludes the function of the Junction Field-Effect Transistor (JFET) with respect to the planar gate IGBT, so there is no JFET effect, the JFET resistance is eliminated, and the on-resistance is reduced, that is, the purpose of reducing the forward voltage drop is achieved. As shown in FIG. 3, which is a schematic cross-sectional structure diagram of a carrier storage-type trench-gate insulated gate bipolar transistor, including an N- drift region 10, a carrier storage region 100, an N buffer region 101, and a P emitter 102, a drain 103, a P- body region 104, a P+ contact region 105, an N+ source region 106, a trench 107, a gate 1071, an isolation dielectric layer 108, a contact hole 1081, and a source electrode 109. In the carrier storage technology, the carrier storage region 100 is formed by doping impurities with an appropriate concentration of impurities in the structure as shown in FIG. 3 in order to improve the conductance modulation effect and achieve the purpose of reducing the forward voltage drop. Although the trench gate technology reduces the forward voltage drop V_{ce}, the gate charge Q_{gc} is also increased, resulting in an increase in the turn-off power loss E_{off}.

Accordingly, there is an urgent need to develop an insulated gate bipolar transistor which can reduce both the forward voltage drop V_{ce} and the turn-off power loss E_{off}.

### SUMMARY

In view of the above shortcomings in the existing technology, the purpose of the present disclosure is to provide an insulated gate bipolar transistor and a manufacturing method thereof to solve the problem of the turn-off power loss E_{off} of the insulated gate bipolar transistor after the forward voltage drop V_{ce} is reduced in the existing technology.

In order to achieve the above purpose and other related purposes, the present disclosure provides a method for manufacturing an insulated gate bipolar transistor with a super junction structure, including:
providing a first conductive type substrate to form a first conductive type drift region, and forming a first conductive type epitaxial layer on an upper surface of the substrate, a doping concentration of the epitaxial layer being higher than a doping concentration of the substrate;
forming a plurality of trenches spaced in the epitaxial layer, and forming a second conductive type filling layer in a trench, an upper surface of the filling layer being lower than a top surface of the epitaxial layer;
forming a gate dielectric layer on an inner wall of the trench and the upper surface of the filling layer, and forming a gate conductive layer in the trench with, a side wall and a bottom surface of the gate conductive layer being wrapped by the gate dielectric layer, an upper surface of the gate conductive layer being lower than the top surface of the epitaxial layer;
forming a second conductive type body region in an upper surface layer of the epitaxial layer on both sides of the trench, forming a second conductive type body contact region and a first conductive type source region adjacent to each other in an upper surface layer of the body region, and forming an isolation dielectric layer covering the upper surface of the epitaxial layer and the upper surface of the gate conductive layer; and
forming a contact hole passing through the isolation dielectric layer to simultaneously expose the source region and the body contact region, and forming a source conductive layer filling the contact hole and covering the isolation dielectric layer.

Optionally, the method for manufacturing the insulated gate bipolar transistor may further include:
thinning the substrate from the bottom surface of the substrate to a preset thickness;
implanting ions from the bottom surface of the substrate successively to form a first conductive type buffer layer and a second conductive type emitter, the buffer layer being located between the drift region and the emitter in a vertical direction;
forming a drain conductive layer electrically connected to the emitter on the bottom surface of the substrate.

Optionally, the first conductive type is opposite to the second conductive type, the first conductive type comprises one of an N-type and a P-type, and the second conductive type comprises the other of the N-type and the P-type.

Optionally, the forming the filling layer may further include:
forming a second conductive type conductive material in the trench and on the upper surface of the epitaxial layer;
removing the conductive material on the upper surface of the epitaxial layer, and removing the conductive material in the trench to a preset depth to form a second conductive type filling layer.

Optionally, the forming the gate conductive layer may include:
forming a gate conductive material in the trench and on the epitaxial layer;
removing the gate conductive material on the epitaxial layer, and removing the gate conductive material in the trench to a preset depth to form the gate conductive layer.

Optionally, the upper surface of the filling layer and a lower surface of the gate conductive layer are lower than a bottom surface of the body region.

The present disclosure further provides an insulated gate bipolar transistor with a super junction structure, including:
a drift region;
an epitaxial layer located on an upper surface of the drift region, a doping concentration of the epitaxial layer being higher than a doping concentration of the substrate;
a plurality of trenches spaced which are located in the epitaxial layer;
a second conductive type filling layer and a gate structure sequentially arranged in the trench from bottom to top, wherein the gate structure comprises a gate dielectric layer and a gate conductive layer, the gate dielectric layer is located on an inner wall of a trench and an upper surface of the filling layer and wraps a side wall and a bottom surface of the gate conductive layer;
a second conductive type body region located in an upper surface layer of the epitaxial layer on both sides of the trench;
a second conductive type body contact region and a first conductive type source region adjacent to each other located in the upper surface layer of the body region;
an isolation dielectric layer covering an upper surface of the source region and the upper surface of the gate conductive layer, wherein a contact hole passing through the isolation dielectric layer is provided in the isolation dielectric layer, the contact hole simultaneously exposes the source region and the body contact region;
a source conductive layer filling the contact hole and covering the isolation dielectric layer.

Optionally, the upper surface of the filling layer and a lower surface of the gate conductive layer are lower than a bottom surface of the body region.

Optionally, the insulated gate bipolar transistor may further include a first conductive type buffer layer, a second conductive type emitter and a drain conductive layer, the buffer layer is located on a back side of the drift region, the emitter is located on a back side of the buffer layer, the drain conductive layer is located on a back side of the emitter.

In view of this, with the insulated gate bipolar transistor with the super junction structure and the manufacturing method thereof, the plurality of trenches spaced are formed in the first conductive type epitaxial layer, and the second conductive type filling layer is formed in the trench, the upper surface of the second conductive type filling layer is lower than the top surface of the epitaxial layer, and then the gate dielectric layer is formed on the side wall of the trench and on the upper surface of the filling layer, and the gate conductive layer is formed in the trench with the side wall and bottom surface of the gate conductive layer wrapped by the gate dielectric layer and the upper surface of the gate conductive layer lower than the top surface of the epitaxial layer, the upper surface of the filling layer and the lower surface of the gate conductive layer are lower than the bottom surface of the body region, the doping concentration of the epitaxial layer is higher than that of the drift region, thereby reducing the forward voltage drop V_{ce}; further, a charge balance is formed between the epitaxial layer and the filling layer; during the process of turning off the transistor, the filling layer quickly extracts the minority carriers in the epitaxial layer and the drift region, thereby reducing the turn-off power loss E_{off}. In addition, the filling layer shields the overlapping area between the bottom portion of the trench and the drift region, thereby reducing the gate charge Q_{gc}, which has a high industrial value.

### BRIEF DESCRIPTION OF THE DRAWINGS

FIG. 1 is a schematic cross-sectional structure diagram of a planar-gate type insulated gate bipolar transistor in the existing technology.
FIG. 2 shows a schematic cross-sectional structure diagram of a trench-gate type insulated gate bipolar transistor in the existing technology.
FIG. 3 shows a schematic cross-sectional structure diagram of a carrier storage-type trench-gate insulated gate bipolar transistor in the existing technology.
FIG. 4 shows a flow chart of a method for manufacturing an insulated gate bipolar transistor with a super junction structure according to the present disclosure.
FIG. 5 is a schematic cross-sectional structure diagram after an epitaxial layer is formed by a method for manufacturing an insulated gate bipolar transistor with a super junction structure according to the present disclosure.
FIG. 6 is a schematic cross-sectional structure diagram after a trench is formed in an epitaxial layer by a method for manufacturing an insulated gate bipolar transistor with a super junction structure according to the present disclosure.
FIG. 7 is a schematic cross-sectional structure diagram after a trench is filled with a second conductive type conductive material by a method for manufacturing an insulated gate bipolar transistor with a super junction structure according to the present disclosure.
FIG. 8 is a schematic cross-sectional structure diagram after a filling layer is formed by a method for manufacturing an insulated gate bipolar transistor with a super junction structure according to the present disclosure.
FIG. 9 is a schematic cross-sectional structure diagram after a gate dielectric layer is formed on an inner wall of a trench and an upper surface of a filling layer by a method for manufacturing an insulated gate bipolar transistor with a super junction structure according to the present disclosure.
FIG. 10 is a schematic cross-sectional structure diagram after a gate conductive material is formed in a trench by a method for manufacturing an insulated gate bipolar transistor with a super junction structure according to the present disclosure.
FIG. 11 is a schematic cross-sectional structure diagram after a gate conductive layer is formed by a method for manufacturing an insulated gate bipolar transistor with a super junction structure according to the present disclosure.
FIG. 12 is a schematic cross-sectional structure diagram after a second conductive type body region, a second conductive type body contact region, and a first conductive type source region are formed by a method for manufacturing an insulated gate bipolar transistor with a super junction structure according to the present disclosure.
FIG. 13 is a schematic cross-sectional structure diagram after an isolation dielectric layer is formed by a method for manufacturing an insulated gate bipolar transistor with a super junction structure according to the present disclosure.
FIG. 14 is a schematic cross-sectional structure diagram after a contact hole is formed by a method for manufacturing an insulated gate bipolar transistor with a super junction structure according to the present disclosure.
FIG. 15 is a schematic cross-sectional structure diagram after a source conductive layer is formed by a method for manufacturing an insulated gate bipolar transistor with a super junction structure according to the present disclosure.
FIG. 16 is a schematic cross-sectional structure diagram after a second conductive type emitter and a first conductive type buffer layer are formed by a method for manufacturing an insulated gate bipolar transistor with a super junction structure according to the present disclosure.
FIG. 17 is a schematic cross-sectional structure diagram after a drain conductive layer is formed by a method for manufacturing an insulated gate bipolar transistor with a super junction structure according to the present disclosure.

### Reference signs:

10, N- drift region;
100, carrier storage region;
101, N buffer;
102, P emitter;
103, drain;
104, P- body region;
105, P+ contact region;
106, N+ source region;
107, trench;
1071, gate;
1072, gate oxide layer;
108, isolation dielectric layer;
1081, contact hole;
109, source;
1, substrate;
11, drift region;
12, emitter;
13, buffer layer;
2, epitaxial layer;
21, trench;
211, filling layer;
2111, conductive material;
212, gate dielectric layer;
213, gate conductive layer;
2131, gate conductive material;
22, body region;
221, body contact region;
23, source region;
3, isolation dielectric layer;
31, contact hole;
4, source conductive layer;
5, drain conductive layer.

### DETAILED DESCRIPTION

The embodiments of the present disclosure will be detailed through specific examples. Those skilled in the art can easily understand other advantages and effects of the present disclosure from the content of the specification. The present disclosure may also be implemented or applied through other different specific embodiments. Various details in the specification may also be modified or transformed in various ways based on different viewpoints and applications without departing from the spirit of the present disclosure.

With reference to FIGS. 4 to 17, it should be noted that the drawings provided in the embodiments only illustrate the basic concept of the present disclosure in a schematic manner. The drawings only show components related to the present disclosure and do not follow the quantity, shapes and dimensioning of the components in the actual implementation. In the actual implementation, the type, quantity and proportion of each component may be changed at will, and the arrangement of the components may also be more complex.

### Embodiment I

In the embodiment, a method for manufacturing an insulated gate bipolar transistor with a super junction structure is provided, referring to FIG. 4 which is a flow chart showing the method for manufacturing the insulated gate bipolar transistor, and the method may include the following steps.

S1: a first conductive type substrate is provided to form a first conductive type drift region, and a first conductive type epitaxial layer is formed on an upper surface of the substrate; a doping concentration of the epitaxial layer is higher than that of the substrate.

S2: a plurality of trenches spaced are formed in the epitaxial layer, and a second conductive type filling layer is formed in the trench, and an upper surface of the filling layer is lower than a top surface of the epitaxial layer.

S3: a gate dielectric layer is formed on an inner wall of the trench and the upper surface of the filling layer, and a gate conductive layer is formed in the trenches with a side wall and a bottom surface of the gate conductive layer wrapped by the gate dielectric layer, and an upper surface of the gate conductive layer is lower than the top surface of the epitaxial layer.

S4: a second conductive type body region is formed in an upper surface layer of the epitaxial layer on both sides of the trench, a second conductive type body contact region and a first conductive type source region adjacent to each other are formed in the upper surface layer of the body region, and an isolation dielectric layer covering the upper surface of the epitaxial layer and the upper surface of the gate conductive layer is formed.

S5: a contact hole passing through the isolation dielectric layer is formed to simultaneously expose the source region and the body contact region, and a source conductive layer is formed, the source conductive layer fills the contact hole and covers the isolation dielectric layer.

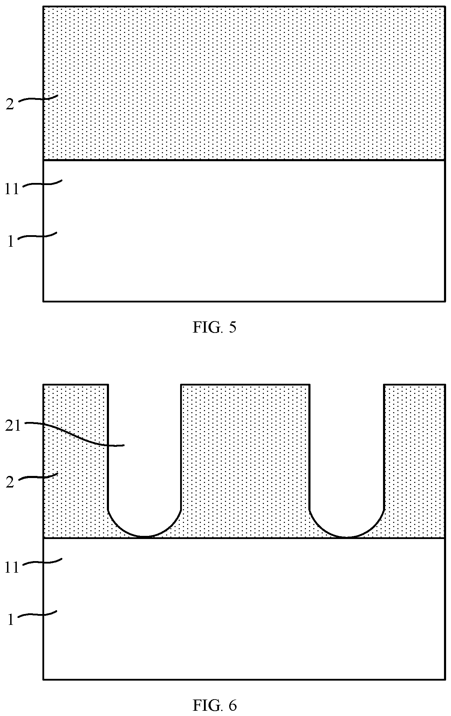

First of all, referring to FIG. 5, the step S1 is performed, i.e., the first conductive type substrate 1 is provided to form the first conductive type drift region 11, and the first conductive type epitaxial layer 2 is formed on the upper surface of the substrate 1; the doping concentration of the epitaxial layer 2 is higher than that of the substrate 1.

Specifically, the material of the substrate 1 may include a first conductive type silicon material or other appropriate semiconductor materials; and the material of the epitaxial layer 2 may include the first conductive type silicon material or other appropriate semiconductor materials.

Specifically, the method for forming the epitaxial layer 2 may include chemical vapor deposition, physical vapor deposition or other appropriate methods.

Specifically, the specific doping concentrations of the substrate 1 and the epitaxial layer 2 are selected according to actual requirements and are not limited herein.

Specifically, a thickness of the epitaxial layer 2 may be set according to actual conditions, and is not limited herein.

Referring to FIGS. 6 to 8, the step S2 is performed, i.e., a plurality of trenches 21 spaced are provided in the epitaxial layer 2, and a second conductive type filling layer 211 is formed in the trenches, and an upper surface of the filling layer 211 is lower than a top surface of the epitaxial layer 2.

As an example, the first conductive type is opposite to the second conductive type, and the first conductive type may include one of N-type and P-type; and the second conductive type may include one of the N-type and P-type. In the embodiment, the first conductive type is N-type, and the second conductive type is P-type.

Specifically, before the trenches 21 are formed, the method may further include that a mask layer is formed on the upper surface of the epitaxial layer 2, and the mask layer is patterned, and then the epitaxial layer 2 is etched to form the trenches 21.

Specifically, as shown in FIG. 6, it is a schematic cross-sectional structure diagram after the trenches 21 are formed. The method for forming the trenches 21 may include wet etching, dry etching or other appropriate methods.

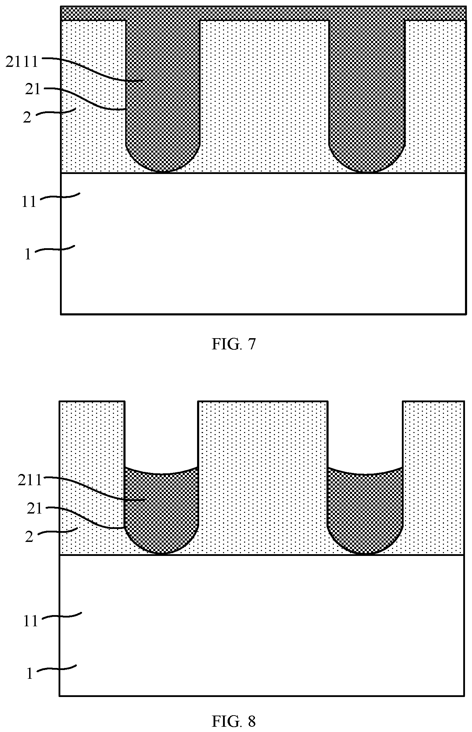

As an example, as shown in FIG. 7, the step of forming the filling layer 211 may further include the following steps:
a second conductive type conductive material 2111 is formed in the trench 21 and on the upper surface of the epitaxial layer 2;
the conductive material 2111 on the upper surface of the epitaxial layer 2 is removed, and the conductive material 2111 in the trench 21 is removed to a preset depth to form a second conductive type filling layer 211.

Specifically, the method for forming the conductive material 2111 in the trenches 21 may include chemical vapor deposition method, physical vapor deposition method or other appropriate methods.

Specifically, the conductive material 2111 may include a second conductive type silicon material or other appropriate semiconductor materials.

Specifically, the method for removing the conductive material 2111 on the upper surface of the epitaxial layer 2 may include chemical mechanical polishing method or other appropriate methods.

Specifically, as shown in FIG. 8, the method for removing the conductive material 2111 in the trenches 21 to the preset depth may include wet etching, dry etching or other appropriate methods.

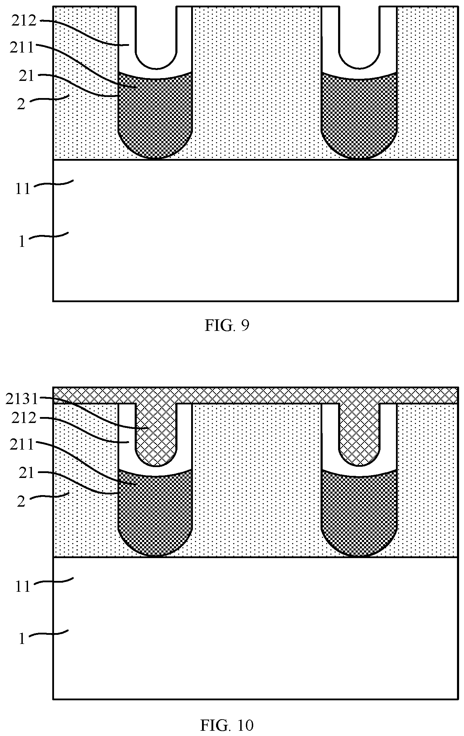

Referring to FIGS. 9 to 13, the steps S3 and S4 are formed, i.e., the gate dielectric layer 212 is formed on the inner walls of the trenches 21 and the upper surface of the filling layer 211, and the gate conductive layer 213 is formed in the trenches 21 with the side wall and the bottom surface of the gate conductive layer 213 wrapped by the gate dielectric layer 212, and the upper surface of the gate conductive layer 213 is lower than the top surface of the epitaxial layer 2; the second conductive type body region 22 is formed in the upper surface layer of the epitaxial layer 2 on both sides of the trench 21, the second conductive type body contact region 221 and the first conductive type source region 23 adjacent to each other are formed in the upper surface layer of the body region 22, and the isolation dielectric layer 3 covering the upper surface of the epitaxial layer 2 and the upper surface of the gate conductive layer 213 is formed.

Specifically, the material of the gate dielectric layer 212 may include a silicon dioxide material or other appropriate materials.

Specifically, as shown in FIG. 9, the method for forming the gate dielectric layer 212 may include chemical vapor deposition method, thermal oxidation method or other appropriate methods, and the thickness of the gate dielectric layer 212 is determined according to the specific conditions, which will not be limited herein. In the embodiment, the thermal oxidation method is adopted to grow a thin gate oxide layer on the side walls of the trenches 21 and the upper surface of the filling layer 211, and the gate oxide layer on the upper surface of the epitaxial layer 2 is removed to form the gate dielectric layer 212.

As an example, the step of forming the gate conductive layer 213 may further include the following steps:
a gate conductive material 2131 is formed in the trench 21 and on the epitaxial layer 2;
the gate conductive material 2131 on the epitaxial layer 2 is removed, and the gate conductive material 2131 in the trench is removed to a preset depth to form the gate conductive layer 213.

Specifically, as shown in FIG. 10, the method for forming the gate conductive material 2131 in the trenches 21 may include the chemical vapor deposition method, physical vapor deposition method or other appropriate methods.

Specifically, the gate conductive material 2131 may include a polysilicon material or other appropriate materials. In the embodiment, the polysilicon material serves as the gate conductive material.

Specifically, the method for removing the gate conductive material 2131 on the upper surface of the epitaxial layer 2 may include a chemical mechanical polishing method or other appropriate methods.

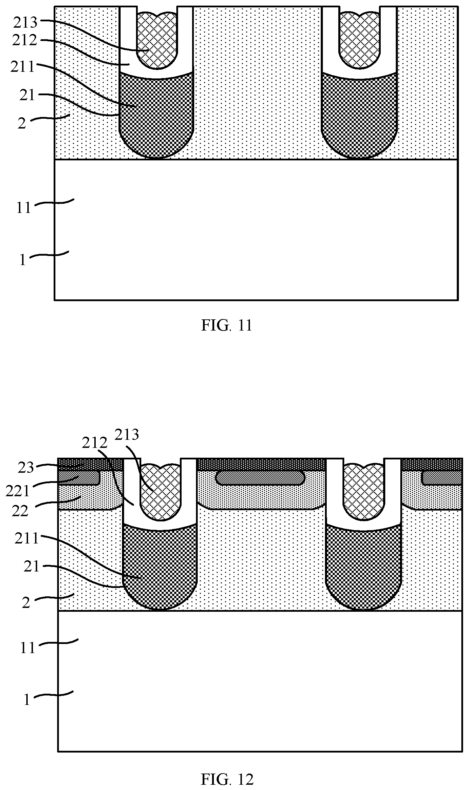

Specifically, as shown in FIG. 11, the method for removing the gate conductive material 2131 in the trenches 21 may include wet etching, dry etching or other appropriate methods.

As an example, the upper surface of the filling layer 211 and a lower surface of the gate conductive layer 213 are lower than a bottom surface of the body region 22.

Specifically, the method for forming the body region 22 may include an ion implantation method or other appropriate methods.

Specifically, the method for forming the body contact region 221 in the body region 22 may include the ion implantation method or other appropriate methods.

Specifically, the doping concentration of the body contact region 221 is higher than the doping concentration of the body region 22.

Specifically, the method for forming the source region 23 in the body region 22 may include the ion implantation method or other appropriate methods. An implantation depth of first conductive type impurity ions in the source region 23 is less than an implantation depth of second conductive type impurity ions in the body region 22. In the embodiment, as shown in FIG. 12, the ion implantation method is adopted to implant the second conductive type impurity ions from above the epitaxial layer 2 into the surface layer of the epitaxial layer 2 to form the body region 22, and partial region of the surface layer of the epitaxial layer 2 continues to be implanted with second conductive type impurity ions to form the body contact region 221, and then the first conductive type impurity ions are implanted from above the epitaxial layer 2 into the surface layer of the epitaxial layer 2 to form the source region 23. The body contact region 221 and the source region 23 are adjacent to the upper surface of the body region 22. The ion implantation depths in body region 22, the body contact region 221 and the source region 23 are determined according to actual conditions and are not limited herein.

Specifically, the body contact region 221 may be arranged side by side with the source region 23.

Specifically, after the body region 22, the body contact region 221 and the source region 23 are formed, an annealing process is performed to activate the impurity ions.

Specifically, silicon nitride, silicon dioxide or other appropriate insulated isolation layers serve as the isolation dielectric layer 3. The thickness of the isolation dielectric layer 3 is set according to the actual situations and is not limited herein.

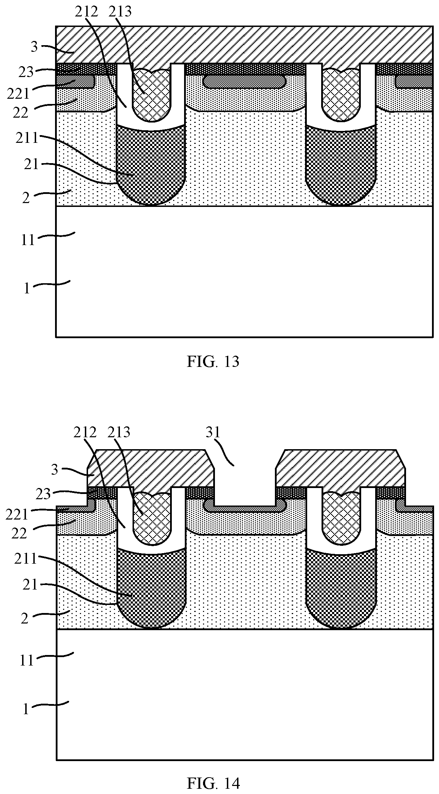

Specifically, as shown in FIG. 13, the chemical vapor deposition method, physical vapor deposition method or other appropriate methods are adopted to form the isolation dielectric layer 3.

Referring again to FIGS. 14 to 17, the step S5 is performed, i.e., the contact hole 31 passing through the isolation dielectric layer 3 is formed to simultaneously expose the source region 23 and the body contact region 221, and the source conductive layer 4 is formed, the source conductive layer 4 fills the contact hole 31 and covers the isolation dielectric layer 3.

Specifically, the step of forming the contact hole 31 may further include that a mask layer is formed on the upper surface of the isolation dielectric layer 3, and the mask layer is patterned, and the contact hole 31 is formed according to the patterned mask layer 31.

Specifically, as shown in FIG. 14, wet etching, dry etching or other suitable methods are adopted to etch the isolation dielectric layer 3 and the epitaxial layer 2 to form the contact hole 31.

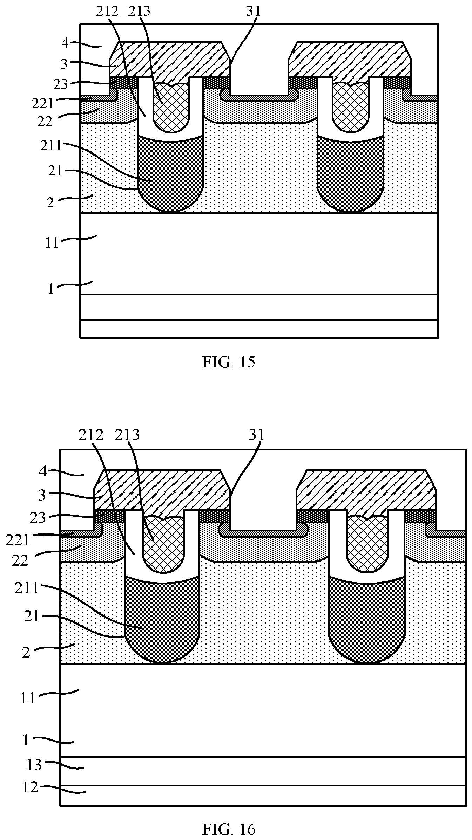

Specifically, as shown in FIG. 15, a sputtering method, the physical vapor deposition method, the chemical vapor deposition method, a metal compound vapor deposition method, a molecular beam epitaxy method, an atomic vapor deposition method, an atomic layer deposition method or other appropriate methods are adopted to form the source conductive layer 4.

Specifically, the material of the source conductive layer 4 may include one of titanium, titanium nitride, silver, gold, copper, aluminum and tungsten, and may also be other appropriate conductive materials.

As an example, after the source conductive layer 4 is formed, the method may further include a step of forming a source passivation layer (not shown) on the upper surface of the source conductive layer 4.

Specifically, the method for forming the source passivation layer may include one of the chemical vapor deposition method, the physical vapor deposition method, and the atomic layer deposition method; or may also be other appropriate methods.

As an example, after the source conductive layer 4 is formed, the method may further include the following steps:
the substrate 1 is thinned from the bottom surface of the substrate 1 to a preset thickness;
ions are implanted from the bottom surface of the substrate 1 successively to form a first conductive type buffer layer 13 and a second conductive type emitter 12; the buffer layer 13 is located between the drift region 11 and the emitter 12 in a vertical direction;
a drain conductive layer 5 electrically connected to the emitter 12 is formed on the bottom surface of the substrate 1.

Specifically, as shown in FIG. 16, it is a schematic cross-sectional structure diagram after the buffer layer 13 and the emitter 12 are formed. The buffer layer 13 is stacked above the emitter 12, that is, the ion implantation depth of the first conductive type impurity ions implanted from below the bottom surface of the substrate 1 to the bottom surface is greater than the ion implantation depth of the second conductive type impurity ions, and after the implantations of the two types of impurity ions are completed, the annealing process is required to activate the impurity ions to form the buffer layer 13 and the emitter 12.

Specifically, the thickness and doping concentration of the emitter 12 are set according to actual conditions and are not limited herein.

Specifically, the thickness and doping concentration of the buffer layer 13 are set according to actual conditions and are not limited herein.

Specifically, the material of the drain conductive layer 5 may include one of titanium, titanium nitride, silver, gold, copper, aluminum and tungsten; or may also be other appropriate conductive materials.

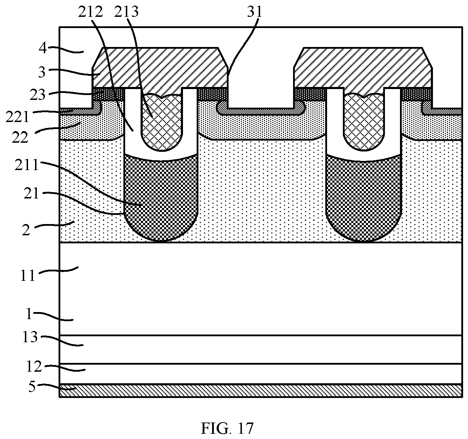

Specifically, as shown in FIG. 17, it is a schematic cross-sectional structure diagram after the drain conductive layer 5 is formed. The sputtering method, the physical vapor deposition method, the chemical vapor deposition method, the metal compound vapor deposition method, the molecular beam epitaxy method, and the atomic vapor deposition method, the atomic layer deposition method or other appropriate methods are adopted to form the drain conductive layer 5.

In the method for manufacturing the insulated gate bipolar transistor with the super junction structure in the embodiment, the second conductive type emitter 12, the first conductive type buffer layer 13 and the first conductive type drift region 11 upwardly stacked are formed in the substrate 1; the plurality of trenches 21 spaced with openings upward are formed in the epitaxial layer 2, and the second conductive type filling layer 211 is formed in the trenches 21, and then the gate dielectric layer 212 is formed on the side walls of the trenches 211 and on the upper surface of the filling layer 211, the gate conductive layer 213 is formed in the trenches 21 with the side wall and bottom surface of the gate conductive layer 213 wrapped by the gate dielectric layer 212 and the upper surface of the gate conductive layer 213 lower than the top surface of the epitaxial layer; the doping concentration of the epitaxial layer 2 is higher than that of the drift region 11 to form a charge balance with the filling layer 211, thereby implementing the reduction of the forward voltage drop of the transistor.

### Embodiment II

In the embodiment, an insulated gate bipolar transistor with a super junction structure is provided. With reference to FIG. 17, which is a schematic cross-sectional structure diagram of the insulated gate bipolar transistor including a drift region 11, an epitaxial layer 2, a plurality of trenches 21 spaced, a second conductive type filling layer 211, a gate structure, a second conductive type body region 22, a second conductive type body contact region 221, a first conductive type source region 23, an isolation dielectric layer 3 and a source conductive layer 4. The epitaxial layer 2 is located on the upper surface of the drift region 11; the doping concentration of the epitaxial layer 2 is higher than that of the drift region 11; and the trenches 21 are located in the epitaxial layer 2; the filling layer 211 and the gate structure are sequentially arranged in the trench 21 from bottom to top. The gate structure includes the gate dielectric layer 212 and the gate conductive layer 213. The gate dielectric layer 212 is located on the inner walls of the trenches 21 and the upper surface of the filling layer 211 and wraps the side wall and the bottom surface of the gate conductive layer 213. The body contact region 221 and the source region 23 are located in the upper surface layer of the body region 22 and adjacent to the body region 22. The isolation dielectric layer 3 covers the upper surface of the source region 23 and the upper surface of the gate conductive layer 213; and a contact hole 31 passing through the isolation dielectric layer 3 is provided in the isolation dielectric layer 3. The contact hole 31 simultaneously exposes the source region 23 and the body contact region 221. The source conductive layer 4 fills the contact hole 31 and covers the isolation dielectric layer 3.

As an example, the upper surface of the filling layer 211 and the lower surface of the gate conductive layer 213 are lower than the bottom surface of the body region 22.

As an example, the insulated gate bipolar transistor may further include a first conductive type buffer layer 13, a second conductive type emitter 12 and a drain conductive layer 5. The buffer layer 13 is located on a back side of the drift region 11. The emitter 12 is located on a back side of the buffer layer 13. The drain conductive layer 5 is located on a back side of the emitter 12.

Specifically, the doping concentration of the buffer layer 12 is higher than the doping concentration of the drift region 11 to generate a conductivity modulation, thereby reducing an internal resistance of the transistor, and further reducing the forward voltage drop V_{ce} of the transistor.

Specifically, the transistor can be regarded as a thick base transistor driven by an MOSFET, and a PN junction is formed between the buffer layer 13 and the emitter 12. In the embodiment, the first conductive type is the N-type and the second conductive type is the P-type, then the MOSFET is an N-channel field effect transistor and the transistor is a PNP-type transistor. When the voltage of the gate conductive layer 213 is greater than a turn-on voltage of the transistor, a channel is formed in the MOSFET and an electron flow is generated. The PN junction formed between the buffer layer 13 and the emitter 12 is turned on, and the emitter 12 injects holes into the buffer layer 13 and the drift region 11, and adjusts the resistivity between the emitter 12 and the buffer layer 13 to reduce the total conduction loss of the transistor.

As an example, a source passivation layer is provided on the upper surface of the source conductive layer 4.

As an example, during the turn-off process of the transistor, the filling layer 211 extracts minority carriers from the epitaxial layer 2 and the drift region 11 to reduce the turn-off power loss E_{off} and further reduce the forward voltage drop V_{ce}.

As an example, the filling layer 211 shields an overlapping area between a bottom portion of the trench 21 and the drift region 11 to reduce the gate charge Q_{gc}, thereby further reducing the forward voltage drop V_{ce}.

In the insulated gate bipolar transistor structure with the super junction structure of the embodiment, the filling layer 211 is provided in the trench 21 below the gate conductive layer 213 to shield the overlapping area between the bottom portion of the gate conductive layer 213 and the drift region 11, in order to reduce the gate charge Q_{gc}; and during the process of turning off the transistor, the filling layer 211 is utilized to extract the minority carriers in the epitaxial layer 2 and the drift region 11, thereby reducing the turn-off power loss E_{off} of the transistor, and further reducing the forward voltage drop V_{ce} of the transistor.

In conclusion, as for the insulated gate bipolar transistor with the super junction structure and the manufacturing method thereof in the present disclosure, the gate structure in the trench is redesigned, and the second conductive type filling layer is formed at the bottom portion of the trench and below the gate conductive layer in the trench to shield the overlapping area between the bottom portion of the trench and the first conductive type drift region, thereby reducing the gate charge Q_{gc}; and the filling layer is utilized to extract the minority carriers from the epitaxial layer and the drift region to reduce the turn-off power loss E_{off} of the transistor; the doping concentrations of the epitaxial layer and the first conductive type buffer layer are higher than the doping concentration of the drift region to produce the conductivity modulation effect, which reduces the internal resistance of the transistor, and further reduces the forward voltage drop V_{ce} of the transistor. Therefore, the present disclosure effectively overcomes various shortcomings in the existing technology and has a high industrial value.

The above embodiments only illustrate the principles and effects of the present disclosure, but are not intended to limit the present disclosure. The skilled in the art can modify or transform the above embodiments without departing from the spirit and scope of the present disclosure. Therefore, all equivalent modifications or transformations made by those with ordinary knowledge in the art without departing from the spirit and technical concept disclosed in the present disclosure shall fall within the scope of the claims of the present disclosure.

## Claims

1. A method for manufacturing an insulated gate bipolar transistor with a super junction structure, comprising:
providing a first conductive type substrate to form a first conductive type drift region, and forming a first conductive type epitaxial layer on an upper surface of the substrate, a doping concentration of the epitaxial layer being higher than a doping concentration of the substrate;
forming a plurality of trenches spaced in the epitaxial layer, and forming a second conductive type filling layer in a trench, an upper surface of the filling layer being lower than a top surface of the epitaxial layer;
forming a gate dielectric layer on an inner wall of the trench and the upper surface of the filling layer, and forming a gate conductive layer in the trench with, a side wall and a bottom surface of the gate conductive layer being wrapped by the gate dielectric layer, an upper surface of the gate conductive layer being lower than the top surface of the epitaxial layer;
forming a second conductive type body region in an upper surface layer of the epitaxial layer on both sides of the trench, forming a second conductive type body contact region and a first conductive type source region adjacent to each other in an upper surface layer of the body region, and forming an isolation dielectric layer covering the upper surface of the epitaxial layer and the upper surface of the gate conductive layer; and
forming a contact hole passing through the isolation dielectric layer to simultaneously expose the source region and the body contact region, and forming a source conductive layer filling the contact hole and covering the isolation dielectric layer.

2. The method for manufacturing the insulated gate bipolar transistor with the super junction structure according to claim 1, further comprising:
thinning the substrate from the bottom surface of the substrate to a preset thickness;
implanting ions from the bottom surface of the substrate successively to form a first conductive type buffer layer and a second conductive type emitter, the buffer layer being located between the drift region and the emitter in a vertical direction;
forming a drain conductive layer on the bottom surface of the substrate and electrically connected to the emitter.

3. The method for manufacturing the insulated gate bipolar transistor with the super junction structure according to claim 2, wherein a doping concentration of the buffer layer is higher than a doping concentration of the drift region.

4. The method for manufacturing the insulated gate bipolar transistor with the super junction structure according to claim 1, wherein the first conductive type is opposite to the second conductive type, the first conductive type comprises one of an N-type and a P-type, and the second conductive type comprises the other of the N-type and the P-type.

5. The method for manufacturing the insulated gate bipolar transistor with the super junction structure according to claim 1, wherein the forming the filling layer comprises:
forming a second conductive type conductive material in the trench and on the upper surface of the epitaxial layer;
removing the conductive material on the upper surface of the epitaxial layer, and removing the conductive material in the trench to a preset depth to form a second conductive type filling layer.

6. The method for manufacturing the insulated gate bipolar transistor with the super junction structure according to claim 1, wherein the forming the gate conductive layer comprises:
forming a gate conductive material in the trench and on the epitaxial layer;
removing the gate conductive material on the epitaxial layer, and removing the gate conductive material in the trench to a preset depth to form the gate conductive layer.

7. The method for manufacturing the insulated gate bipolar transistor with the super junction structure according to claim 1, wherein the upper surface of the filling layer and a lower surface of the gate conductive layer are lower than a bottom surface of the body region.

8. The method for manufacturing the insulated gate bipolar transistor with the super junction structure according to claim 1, further comprising:
forming a source passivation layer on an upper surface of the source conductive layer.

9. The method for manufacturing the insulated gate bipolar transistor with the super junction structure according to claim 1, wherein the doping concentration of the epitaxial layer is higher than a doping concentration of the drift region.

10. An insulated gate bipolar transistor with a super junction structure, comprising:
a drift region;
an epitaxial layer located on an upper surface of the drift region, a doping concentration of the epitaxial layer being higher than a doping concentration of the substrate;
a plurality of trenches spaced which are located in the epitaxial layer;
a second conductive type filling layer and a gate structure sequentially arranged in the trench from bottom to top, wherein the gate structure comprises a gate dielectric layer and a gate conductive layer, and the gate dielectric layer is located on an inner wall of a trench and an upper surface of the filling layer and wraps a side wall and a bottom surface of the gate conductive layer;
a second conductive type body region located in an upper surface layer of the epitaxial layer on both sides of the trench;
a second conductive type body contact region and a first conductive type source region adjacent to each other located in an upper surface layer of the body region;
an isolation dielectric layer covering an upper surface of the source region and an upper surface of the gate conductive layer, wherein a contact hole passing through the isolation dielectric layer is provided in the isolation dielectric layer, and the contact hole simultaneously exposes the source region and the body contact region; and
a source conductive layer filling the contact hole and covering the isolation dielectric layer.

11. The insulated gate bipolar transistor with the super junction structure according to claim 10, wherein the upper surface of the filling layer and a lower surface of the gate conductive layer are lower than a bottom surface of the body region.

12. The insulated gate bipolar transistor with the super junction structure according to claim 10, further comprising a first conductive type buffer layer, a second conductive type emitter and a drain conductive layer, wherein the buffer layer is located on a back side of the drift region, the emitter is located on a back side of the buffer layer, the drain conductive layer is located on a back side of the emitter.

13. The insulated gate bipolar transistor with the super junction structure according to claim 12, wherein a doping concentration of the buffer layer is higher than a doping concentration of the drift region.

14. The insulated gate bipolar transistor with the super junction structure according to claim 10, wherein the first conductive type is opposite to the second conductive type, the first conductive type comprises one of an N-type and a P-type, and the second conductive type comprises the other of the N-type and the P-type.

15. The insulated gate bipolar transistor with the super junction structure according to claim 10, wherein a source passivation layer is provided on the upper surface of the source conductive layer.
